Europäisches Patentamt

European Patent Office

Office européen des brevets

(11) Veröffentlichungsnummer: **0 303 880 B1**

(12) **EUROPÄISCHE PATENTSCHRIFT**

(45) Veröffentlichungstag der Patentschrift: 06.11.91

(51) Int. Cl.5: **G01N 33/38**

(21) Anmeldenummer: 88112471.3

(22) Anmeldetag: 01.08.88

(54) Elektrischer Magnet für Kernspin-Thomographen.

(30) Priorität: 14.08.87 DE 3727234

(43) Veröffentlichungstag der Anmeldung:
22.02.89 Patentblatt 89/08

(45) Bekanntmachung des Hinweises auf die
Patenterteilung:
06.11.91 Patentblatt 91/45

(84) Benannte Vertragsstaaten:
DE GB

(56) Entgegenhaltungen:
EP-A- 0 151 036
EP-A- 0 167 059
EP-A- 0 216 404
EP-A- 0 222 281
EP-A- 0 272 411

PATENT ABSTRACTS OF JAPAN, Band 8, Nr.
163 (P-290)[1600], 27. July 1984; & JP-A-59 60
346

REVIEW OF SCIENTIFIC INSTRUMENTS, Band
56, Nr. 1, Januar 1985, Seiten 131-135, Woodbury, N.Y., US; D.I. HOULT et al.: "Shimming a
superconducting nuclear-
magnetic-resonance imaging magnet with
steel"

MAGNETIC RESONANCE IN MEDICINE, Band
1, Nr. 1, März 1984, Seiten 44-65, New York,
US; F. ROMEO et al.: "Magnet field profiling:
analysis and correcting coil design"

(73) Patentinhaber: SIEMENS AKTIENGESELL-
SCHAFT
Wittelsbacherplatz 2
W-8000 München 2(DE)

(72) Erfinder: Pausch, Günther
Peter-Vischer-Ring 11
W-8521 Effeltrich(DE)

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft einen elektrischen Magneten für Kernspin-Tomographen, wobei zur Homogenisierung des Magnetfeldes im Magneten eine das Homogenitätsvolumen des Magneten umfassende Fläche vorgesehen ist zur Anbringung von Eisenplättchen derart, daß durch eine geeignete Form, Größe, Anordnung und Anzahl der Eisenplättchen das Magnetfeld homogenisierbar ist.

Ein derartiger Magnet ist aus der EP-A2-0 167 059 bekannt. Dabei erfolgt die Homogenisierung des Magnetfeldes, auch Shimmung genannt, mit Hilfe von Eisenplättchen, ohne daß hierzu stromdurchflossene Spulen erforderlich sind oder unter Reduzierung der Anzahl solcher Spulen. Dabei sind an den Stirnwänden des Magneten sternförmige Taschen vorgesehen, in denen Eisenplättchen stapelbar sind. Auch an der Außenseite des Magneten sind in Längsrichtung Taschen zur Aufnahme von Plättchen vorgesehen. Schließlich enthält der Magnet ein Kunststoffrohr, an dessen Innenseite ebenfalls Eisenplättchen befestigt werden können. Diese Eisenplättchen dienen zur Kompensation von Inhomogenitäten, die durch magnetische Rückführungen am Magneten erzeugt werden. Durch geeignete Wahl der Form, Größe, Anordnung und Anzahl dieser Eisenplättchen ist eine Homogenisierung des Magnetfeldes im Rahmen der gewünschten Genauigkeit möglich.

Mit bekannten mathematischen Methoden zur Feldberechnung wird dabei zunächst die Position und die Dimension einzelner Plättchen zur Korrektur festgelegt. Dann muß die rechnerisch bestimmte Position für ein bestimmtes Plättchen auf das Kunststoffrohr übertragen werden. Die dabei erforderlichen Toleranzen erfordern entweder ein sehr aufwendiges Vorgehen oder führen bei Nichtbeachtung zu unbefriedigenden Ergebnissen.

Aufgabe der Erfindung ist es daher, einen elektrischen Magneten der eingangs genannten Art so auszuführen, daß die Übertragung der rechnerisch bestimmten Plättchenanordnungen in das Anlagensystem vereinfacht wird.

Diese Aufgabe wird erfindungsgemäß wie in Anspruch 1 definiert gelöst. Dabei wird die Fläche, die zylinderförmig ist, in Längs- und Umfangsrichtung fest in einzelne, nicht überlappende Flächenelemente eingeteilt, wobei jedes Flächenelement mit einem oder mehreren Eisenplättchen bestückbar ist. Damit ist der genaue Ort der anzubringenden Eisenplättchen unabhängig von einem speziellen Magneten oder einem speziellen Aufstellungsort desselben bereits festgelegt. Aufgrund von Feldberechnungen muß lediglich noch die Anzahl sowie eventuell die Dimension der am jeweiligen Flächenelement anzuordnenden Eisenplättchen festgelegt werden.

Die exakte Positionierung kann dadurch besonders erleichtert werden, daß jedes Flächenelement mindestens eine Halterung zur Befestigung der zugeordneten Eisenplättchen aufweist. Am einfachsten können hierfür Gewindebohrungen vorgesehen sein. Die aufgrund der Magnetfeldberechnung erforderliche Anzahl von Plättchen muß dann lediglich auf das jeweilige Flächenelement aufgeschraubt werden.

Bei einem Verfahren zur Homogenisierung kann vorteilhafterweise ein für einen Magnettyp standardisierter Satz von Eisenplättchen mit einheitlicher Anordnung von Befestigungspunkten und unterschiedlichen Dimensionen zur Verfügung stehen, wobei die Belegung der Flächenelemente mit einem oder mehreren dieser Plättchen aufgrund einer Berechnung der notwendigen Korrekturen nach einem an sich bekannten mathematischen Verfahren erfolgt.

Mit einem - unabhängig vom speziellen Magneten und dessen Aufstellungsort - standardisierten Vorrat an Eisenplättchen kann man daher praktisch für jede Anlagenkonfiguration eine Homogenisierung des Magnetfeldes erreichen.

Ein Ausführungsbeispiel der Erfindung wird nachfolgend anhand der FIG 1 bis 3 näher erläutert. Es zeigen:

FIG 1      die schematische Anordnung eines Magneten,

FIG 2      die Anordnung von Eisenplättchen auf einem Kunststoffzylinder,

FIG 3      eine Anordnung der Eisenplättchen auf der Außenseite des Magneten.

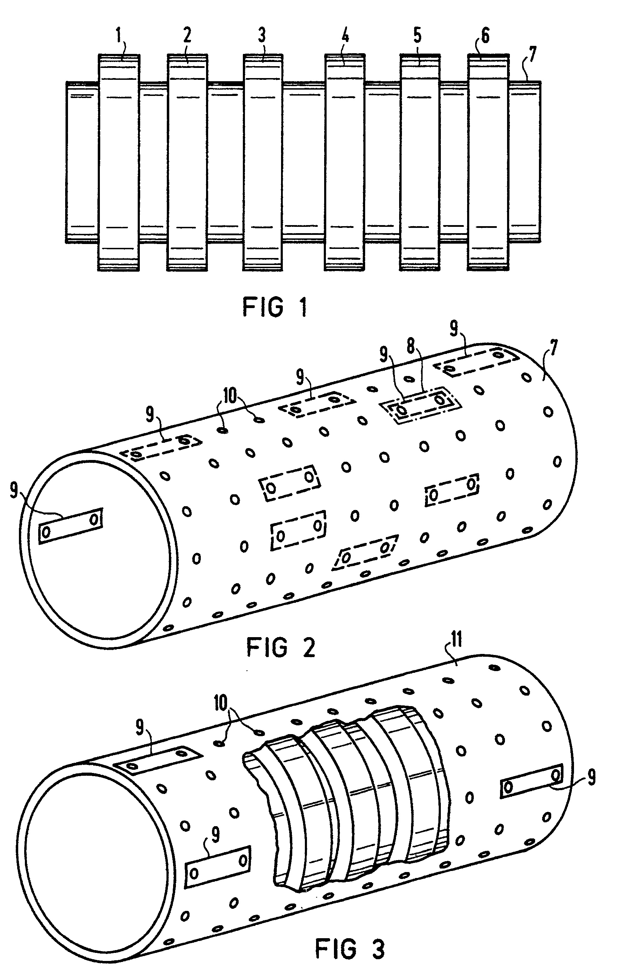

Wie in FIG 1 dargestellt, bestehen Magneten für Kernspin-Tomographen z.B. aus sechs Spulen 1 bis 6 in Helmholtz-Anordnung. Bei supraleitenden Magneten sind diese Spulen 1 bis 6 in einem mit flüssigem Helium gefüllten Kryostaten angeordnet. Die Spulen 1 bis 6 umschließen einen Kunststoff-Hohlzylinder 7, dessen Innenraum als Untersuchungsbereich dient.

Bei Kernspin-Tomographen werden hohe Anforderungen an die Homogenität des Magnetfeldes gestellt.

Zu dieser Homogenisierung werden auf der Innenseite des Kunststoff-Hohlzylinders 7 Eisenplättchen 9 aufgebracht. Die Innenfläche des Kunststoff-Hohlzylinders 7 ist in eine Vielzahl sich nicht überlappender Flächenelemente eingeteilt. Ein solches Flächenelement ist in FIG 2 symbolisch mit 8 gekennzeichnet. Dabei muß die Gesamtheit der Flächenelemente 8 die gegebene Innenfläche des Hohlzylinders 7 nicht notwendigerweise vollständig überdecken, es können also Lücken zwischen den Flächenelementen 8 bleiben. Die Einteilung der Flächenelemente 8 ist unabhängig von einem speziellen Magneten oder einem speziellen Aufstellungsort.

Im Ausführungsbeispiel weist jedes der Flächenelemente 8 zwei Gewindebohrungen 10 auf.

Durch geeignete Wahl dieser Flächeneinteilung läßt sich die Anzahl der Freiheitsgrade minimieren, ohne die Möglichkeiten der Feldkorrektur wesentlich einzuschränken.

Als besonders vorteilhaft hat es sich erwiesen, die Ausdehnung der Flächenelemente 8 in Längsrichtung von der Mitte des Fläche nach außen zu zunehmen zu lassen, wobei sich aufeinanderfolgende Flächen elemente 8 berühren.

In Umfangsrichtung ist eine lückenlose Anordnung der Flächenelemente 8 dagegen nicht notwendig. Größe und Anordnung der Lücken in Umfangsrichtung sind im wesentlichen vom Radiusverhältnis des Homogenitätsvolumens zu den Flächenelementen 8 und von deren Breite abhängig. Im vorliegenden Ausführungsbeispiel genügen 16 äquidistant am Umfang verteilte Winkelpositionen.

Durch die Flächenelemente 8 sind nun die möglichen Positionen für die Eisenplättchen 9 vorgegeben. Durch ein mathematisches Verfahren muß lediglich eine geeignete Belegung der vorbestimmten Positionen (Flächenelemente 8) mit Eisenplättchen ermittelt werden. Für die Belegung kann je Anlage ein standardisierter Satz von Eisenplättchen mit einheitlicher Anordnung von Bohrungen im Abstand der Gewindelöcher 8 vorgesehen werden. Die Eisenplättchen 9 können in der Länge, Breite und/oder der Dicke in Stufen variieren.

Für ein ferromagnetisches Material gegebener Magnetisierung und gegebener Dicke, das eines der Flächenelemente überdeckt, kann dessen Wirkung in einem festgelegten Aufpunktraster berechnet werden. Ein solches Berechnungsverfahren ist beispielsweise angegeben von Romeo, Hoult "Magnetic Field Profiling, Analysis and Correcting Coil Design", Magnetic Resonance in Medicine 1, 1984 (44 - 65). Es gibt eine Reihe geeigneter Optimierungsverfahren, beispielsweise beschrieben in: Vanderplaats "Numerical Optimization Techniques for Engineering Design" Mc Graw Hill, NY, 1984, S. 140-147, mit deren Hilfe zu einer gegebenen Verteilung von Feldabweichungen ΔB eine Belegung der Flächenelemente 8 so bestimmt werden kann, daß die Homogenität optimal im Sinne des verwendeten Algorithmus ist.

Aufgrund dieser Berechnungsverfahren werden dann die Flächenelemente 8 mit einem oder mehreren Plättchen aus dem zur Verfügung stehenden standardisierten Satz von Plättchen belegt. Dabei tritt aufgrund der vorgegebenen Positionierung keinerlei Problem mit der Übertragung der Rechenergebnisse auf die vorhandene Geometrie auf.

Nach Belegung der Flächenelemente 8 mit entsprechenden Eisenplättchen sind die Feldinhomogenitäten im Untersuchungsbereich minimiert.

Mit dem beschriebenen Verfahren können hochhomogene Grundfelder ausschließlich durch passive Maßnahmen, d.h. ohne Shim-Spulen erzeugt werden. Dabei müssen weder Plättchen zugeschnitten werden noch individuelle Befestigungspunkte geschaffen werden, so daß dieses Verfahren einfach und schnell anzuwenden ist.

Dasselbe Verfahren läßt sich, wie in FIG 3 dargestellt, auch auf vorgegebene Positionen der äußeren Mantelfläche 11 des Magneten anwenden. Dabei wird zwar der Einfluß der Eisenplättchen 9 auf das Magnetfeld geringer, dafür ist aber die Zugänglichkeit bei montiertem Kernspin-Tomographen besser.

**Patentansprüche**

1. Elektrischer Magnet für Kernspin-Tomographen, wobei zur Homogenisierung des Magnetfeldes im Magneten eine das Homogenitätsvolumen des Magneten umfassende Fläche (7) vorgesehen ist zur Anbringung von Eisenplättchen (9) derart, daß durch eine geeignete Form, Größe, Anordnung und Anzahl der Eisenplättchen (9) das Magnetfeld homogenisierbar ist,
**dadurch gekennzeichnet,**
daß die Fläche (7) zylinderförmig ist und in Längs- und Umfangsrichtung fest in einzelne, nicht überlappende Flächenelemente (8) eingeteilt ist, wobei durch diese Flächenelemente (8) der genaue Ort der anzubringenden Eisenplättchen (9) unabhängig von einem speziellen Magneten oder einem speziellen Aufstellungsort festgelegt ist und aufgrund von Feldberechnungen die Anzahl und gegebenenfalls die Dimension der Eisenplättchen (9), mit denen die Flächenelemente (8) bestückt werden, festgelegt werden.

2. Elektrischer Magnet nach Anspruch 1,
**dadurch gekennzeichnet,**
daß jedes Flächenelement (8) mindestens eine Halterung (10) zur Befestigung der zugeordneten Eisenplättchen (9) aufweist.

3. Elektrischer Magnet nach Anspruch 1 oder 2,
**dadurch gekennzeichnet,.**
daß die Fläche (7) auf der äußeren Mantelfläche (11) des Magneten liegt.

4. Elektrischer Magnet nach einem der Ansprüche 1 bis 3,
**dadurch gekennzeichnet,**
daß die Ausdehnung der Flächenelemente (8) in Längsrichtung der Fläche (7) von der Mitte der Fläche nach außen zu zunimmt, wobei aufein anderfolgende Flächenelemente (8) sich berühren.

5. Elektrischer Magnet nach einem der Ansprüche 1 bis 4,
**dadurch gekennzeichnet,**
daß die Flächenelemente (8) in Umfangsrichtung der Fläche (7) äquidistant angeordnet sind und zwischen aufeinanderfolgenden Flächenelementen (8) Lücken bleiben.

6. Verfahren zur Homogenisierung des Magnetfeldes bei einem Magneten nach einem der Ansprüche 1 bis 5,
**dadurch gekennzeichnet,**
daß ein für einen Magnettyp standardisierter Satz von Eisenplättchen (9) mit einheitlicher Anordnung von Befestigungspunkten und unterschiedlichen Dimensionen zur Verfügung steht und daß die Belegung der Flächenelemente (8) mit einem oder mehreren dieser Eisenplättchen (9) aufgrund einer Berechnung der notwendigen Korrekturen nach einem an sich bekannten mathematischen Verfahren erfolgt.

**Claims**

1. Electric magnet for nuclear spin tomographs, in which, for homogenising the magnetic field in the magnet, a surface (7) surrounding the homogeneity volume of the magnet is provided for the attachment of iron platelets (9) in such a way that, by the suitable shape, size, arrangement and number of iron platelets (9), the magnetic field can be homogenised, **characterised in that** the surface (7) is cylindrical and, in the longitudinal and peripheral direction, is divided in fixed manner into individual, non-overlapping surface elements (8), the precise location of the iron platelets (9) to be attached being determined, independently of a particular magnet or a particular place of installation, by these surface elements (8) and, on the basis of field calculations, the number and possibly the dimensions of the iron platelets (9) with which the surface elements (8) are equipped being determined by these surface elements.

2. Electric magnet according to claim 1, **characterised in that** each surface element (8) has at least one support (10) for the attachment of the associated iron platelets (9).

3. Electric magnet according to claim 1 or 2, **characterised in that** each surface (7) is located on the outer lateral surface (11) of the magnet.

4. Electric magnet according to one of claims 1 to 3, **characterised in that** the dimension of the surface elements (8) in the longitudinal direction of the surface (7) increases from the centre of the surface outwards, with successive surface elements (8) touching.

5. Electric magnet according to one of claims 1 to 4, **characterised in that** the surface elements (8) are arranged at an equal distance from each other in the peripheral direction of the surface (7), and gaps remain between successive surface elements (8).

6. Method for homogenising the magnetic field in the case of a magnet according to one of claims 1 to 5, **characterised in that** a set of iron platelets (9) standardised for a type of magnet, having a uniform arrangement of attachment points and different dimensions, is available, and in that covering of the surface elements (8) with one or several of these iron platelets (9) on the basis of a calculation of the necessary corrections takes place according to a mathematical procedure known per se.

**Revendications**

1. Électroaimant pour un tomographe à spin nucléaire, dans lequel, pour homogénéiser le champ magnétique, il est prévu, dans l'aimant, une surface (7), qui entoure le volume d'homogénéité de l'aimant, pour le montage de plaquettes de fer (9) de telle sorte que le champ magnétique peut être homogénéisé au moyen de la forme, de la taille, d'une disposition et d'un nombre appropriés des plaquettes de fer (9), caractérisé par le fait que la surface (7) possède une forme cylindrique et est subdivisée de façon fixe, dans la direction longitudinale et dans la direction circonférentielle, en différents éléments de surface (8) non en chevauchement, ces éléments de surface (8) déterminant l'emplacement précis auquel la plaquette de fer (9) doit être installée, indépendamment d'un aimant particulier ou d'un emplacement particulier de montage, alors que sur la base de calculs du champ, on détermine le nombre et éventuellement la dimension des plaquettes de fer (9), avec lesquelles les éléments de surface (8) doivent être garnies.

2. Électroaimant suivant la revendication 1, caractérisé par le fait que chaque élément de surface (8) possède au moins un support (10) servant à fixer les plaquettes de fer (9) associées.

3. Électroaimant suivant la revendication 1 ou 2, caractérisé par le fait que la surface (7) est

situeé sur la surface enveloppe extérieure (11) de l'aimant.

4. Électroaimant suivant l'une des revendications 1 à 3, caractérisé par le fait que l'étendue des éléments de surface (8) dans la direction longitudinale de la surface (7) augmente en direction de l'extérieur à partir du centre de la surface, des éléments de surface successifs (8) étant en contact réciproque.

5. Électroaimant suivant l'une des revendications 1 à 4, caractérisé par le fait que les éléments de surface (8) sont disposés en étant équidistants dans la direction circonférentielle de la surface (7) et que des intervalles vides subsistent entre des éléments de surface (8) successifs.

6. Procédé pour homogénéiser le champ magnétique dans un aimant suivant l'une des revendications 1 à 5, caractérisé par le fait que pour un type d'aimant, on dispose d'un jeu normalisé de plaquettes de fer (9) avec une disposition uniforme de points de fixation et avec des dimensions différentes et que le placement sur les éléments de surface (8) d'une ou de plusieurs de ces plaquettes de fer (9) se détermine sur la base d'un calcul des corrections nécessaires, suivant un procédé mathématique connu en soi.

FIG 1

FIG 2

FIG 3